## Europäisches Patentamt

## European Patent Office

## Office européen des brevets

(11) Veröffentlichungsnummer: **0 073 399
B1**

(12) **EUROPÄISCHE PATENTSCHRIFT**

(45) Veröffentlichungstag der Patentschrift:
**12.03.86**

(21) Anmeldenummer: **82107447.3**

(22) Anmeldetag: **16.08.82**

(51) Int. Cl.⁴: **G 01 N 24/06,** H 01 F 7/20,
A 61 B 5/05

(54) Gradientenspulen-System einer Einrichtung der Kernspinresonanz-Technik.

(30) Priorität: **27.08.81 DE 3133933**

(43) Veröffentlichungstag der Anmeldung:
**09.03.83 Patentblatt 83/10**

(45) Bekanntmachung des Hinweises auf die Patenterteilung:
**12.03.86 Patentblatt 86/11**

(84) Benannte Vertragsstaaten:
**DE FR GB NL**

(56) Entgegenhaltungen:
**DE - A - 2 611 497
DE - A - 2 755 956
DE - A - 2 840 178**

(73) Patentinhaber: **Siemens Aktiengesellschaft, Berlin und München Wittelsbacherplatz 2, D-8000 München 2 (DE)**

(72) Erfinder: **Frese, Georg, Dipl.-Phys., Weiherstrasse 15, D-8520 Erlangen (DE)**
Erfinder: **Siebold, Horst, Dr., Starenweg 3, D-8520 Erlangen (DE)**

ACTORUM AG

## Beschreibung

Die Erfindung bezieht sich auf ein Gradientenspulen-System für eine Einrichtung zur Erzeugung von Abbildungen eines Objektes mit Hilfe der Kernspinresonanz-Technik, insbesondere für die Zeugmatographie, mit
- einem rotationssymmetrischen Trägerkörper, der einen Abbildungsbereich umschliesst und dessen die z-Achse eines rechtwinkeligen x-y-z-Koordinatensystems definierende Rotationsachse der Richtung des Grundmagnetfeldes $B_z$ der Einrichtung entspricht,
- zwei Paaren von ringförmigen Einzelspulen, die zur Erzeugung eines in dem Abbildungsbereich im wesentlichen konstanten Magnetfeldgradienten $G_z = \partial B_z/\partial z$ entlang der z-Achse auf dem Trägerkörper angeordnet sind, wobei das eine Paar von ringförmigen Einzelspulen symmetrisch zu dem anderen Paar von ringförmigen Einzelspulen bezüglich einer durch den Abbildungsbereich senkrecht zur z-Achse verlaufenden und die x-y-Ebene des Koordinatensystems bildenden Querschnittsebene angeordnet ist, und wobei die Stromflussrichtung in den Einzelspulen des einen Paares zur Stromflussrichtung in den Einzelspulen des anderen Paares entgegengesetzt ist, sowie
- mindestens einem Satz von bezüglich der Querschnittsebene symmetrischen und zur Erzeugung von in dem Abbildungsbereich im wesentlichen konstanten Feldgradienten $G_x = \partial B_z/\partial x$ in x-Richtung angeordneten Einzelspulen und mindestens einem weiteren Satz von Einzelspulen zur Erzeugung entsprechender Feldgradienten $G_y = \partial B_z/\partial y$ in y-Richtung. Ein solches Gradientenspulen-System ist aus der DE-A 28 40 178 bekannt.

Auf dem Gebiet der medizinischen Diagnostik sind Abbildungsverfahren vorgeschlagen worden, bei denen durch rechnerische oder messtechnische Analyse integraler Protonenresonanzsignale aus der räumlichen Spindichte- und/oder Relaxationszeitenverteilung eines zu untersuchenden menschlichen Körpers ein Bild ähnlich einem Röntgentomogramm konstruiert wird. Die entsprechende Methode wird auch als Zeugmatographie bzw. Kernspintomographie bezeichnet («Nature», Band 242, 1973, Seiten 190 bis 191).

Zur Kernspintomographie nach bekannten Verfahren werden prinzipiell drei verschiedene Arten von Spulensystemen benötigt. Danach ist ein Magnet zur Erzeugung eines möglichst homogenen, stationären Grundfeldes $B_z$ in der Grössenordnung von 0,05 bis 0,5 Tesla erforderlich. Dieses Magnetfeld $B_z$ sei z.B. in z-Richtung eines rechtwinkligen x-y-z-Koordinantensystems orientiert, die zugleich die Untersuchungsachse ist, längs derer ein zu untersuchender, insbesondere menschlicher Körper in das Magnetfeld eingebracht wird. Der Koordinatenursprung soll dabei in den Abbildungs- bzw. Untersuchungsbereich gelegt sein. Ferner ist eine Hochfrequenz-Spulenanordnung für die entsprechende Präzessionsfrequenz der zu betrachtenden Kernspins vorzusehen, um die Kernspins anzuregen und gegebenenfalls auch die Induktionssignale empfangen zu können. Falls die Hochfrequenz-Spulenanordnung nicht zur Detektion dieser Signale mit verwendet wird, kann auch ein besonderes Empfangsspulensystem vorgesehen sein. Schliesslich wird noch ein System von Gradientenspulen benötigt, die einen vorzugsweise orthogonalen Satz

von Zusatzfeldern $G_z = \dfrac{\partial B_z}{\partial z}$, $G_x = \dfrac{\partial B_z}{\partial x}$ und $G_y = \dfrac{\partial B_z}{\partial y}$ erzeugen. Diese Zusatzfelder sind klein gegen das in z-Richtung orientierte Grundfeld $B_z$.

Erst die in einer vorbestimmten Reihenfolge eingeschalteten Gradientenfelder erlauben eine Unterscheidung im Ort durch einen Verlauf der Präzessionsfrequenz der Kerne über dem Ort (vgl. z.B. «Journal of Magnetic Resonance», Vol. 18, 1975, Seiten 69 bis 83, oder Vol. 29, 1978, Seiten 355 bis 373).

Sind diese Gradienten $G_x$, $G_y$ und $G_z$ in einem Abbildungsbereich nicht zumindest weitgehend konstant, sondern noch Funktionen vom Ort selbst, so entstehen Bild-Unschärfen, -Verzerrungen und -Artefakte. Die Linearität der Gradientenfelder bzw. die Konstanz ihrer Ableitungen $G_x$, $G_y$, $G_z$ in dem Abbildungsbereich ist deshalb eine wesentliche Voraussetzung für eine gute Bildqualität von Kernspintomographie-Apparaturen.

Allgemein lassen sich die genannten Feldgradienten $G_x$, $G_y$ und $G_z$ durch magnetische Quadrupole erzeugen. Für Einrichtungen der Kernspinresonanz-Technik muss dabei berücksichtigt werden, dass die Spulen zur Erzeugung der Gradienten im Inneren des Grundfeldmagneten angeordnet werden müssen, wobei für die Lagerung des zu untersuchenden, insbesondere menschlichen Körpers genügend Raum offen bleiben muss.

Die Geometrie entsprechender Spulensysteme ist analytisch abgeleitet worden (vgl. z.B. die US-A 3 569 823). Danach sollen die Spulen jeweils eine Ordnung des in Kugelfunktionen entwickelten Magnetfeldes möglichst rein wiedergeben. Hierbei ist davon ausgegangen, dass ihre felderzeugenden Leiter auf der Aussen- und/oder Innenmantelfläche eines hohlzylindrischen Trägerkörpers angeordnet sind. Bei dieser Anordnung sind Störungen der Hauptkugelfunktionen, die durch eine endliche Länge der Leiter und deren Lage entstehen, analytisch minimiert.

Der hohlzylindrische Trägerkörper mit den entsprechenden Gradientenspulen kann in einen Grundfeldmagneten eingeschoben werden, wobei seine Achse auf die Achse des Grundmagneten fällt, welche z.B. in z-Richtung eines rechtwinkligen x-y-z-Koordinatensystems weist. Der z-Gradient $G_z$ wird durch zwei gegensinnig stromdurchflossene Ringspulen erzeugt. Zur Erzeugung des x-Gradienten $G_x$ sind zwei Sattelspulen-Paare auf den Trägerkörper aufgebracht. Für den y-Gradienten $G_y$ ist ein entsprechendes System von vier Sattelspulen vorgesehen, die gegenüber den x-Gradientenspulen auf dem Zylindermantel um 90° in Umfangsrichtung versetzt angeordnet sind.

Bei der Berechnung dieses Spulensystems ist davon ausgegangen, dass eine gute Linearität der Gradientenfelder in einer radialen x-y-Ebene erreicht wird. Für die Aufnahme von Ganzkörperbildern mit einer Einrichtung der Kernspinresonanz-Technik wird jedoch eine Linearität dieser Felder nicht nur in einem ebenen, flächenhaften Abbildungsbereich, sondern in einem kugelförmigen Volumen mit einem Radius von beispielsweise 20 cm gefordert. Man möchte nämlich die Bildebene beliebig im Raum orientieren können. Das bedeutet aber, dass auch die Linearität der Gradientenfelder über dieses gesamte Volumen zu fordern ist. Hierbei sollen die Gradienten bis unter beispielsweise 5% konstant sein, um wesentliche Verzerrungen des Bildes zu vermeiden.

Diese Forderung kann mit der aus der eingangs genannten DE-A 2 840 178 oder mit der aus der vorveröffentlichten europäischen Patentanmeldung EP-A 21 535 zu entnehmenden Magnetspulenanordnung weitgehend erfüllt werden. Das Gradientenspulen-System dieser bekannten Magnetspulenanordnung ist hierzu nicht auf einem hohlzylindrischen Trägerkörper, sondern auf einem Trägerkörper mit kugelförmiger Gestalt angeordnet. Die Untersuchungsachse, die zugleich eine Rotationsachse dieses Trägerkörpers darstellt, verläuft dabei in z-Richtung eines rechtwinkligen x-y-z-Koordinatensystems, wobei in das Untersuchungs- bzw. Abbildungszentrum der Koordinatenursprung gelegt ist. Zur Erzeugung der Feldgradienten $G_z$ in z-Richtung sind nicht wie bei der Magnetspulenanordnung gemäss der genannten US-A 3 569 823 zwei ringförmige Einzelspulen vorgesehen, sondern nunmehr je ein zumindest annähernd symmetrisch zu der x-y-Ebene durch das Zentrum des Abbildungsbereiches angeordnetes Paar von zwei ringförmigen Einzelspulen. Die Stromflussrichtung in den Einzelspulen des einen Paares ist dabei entgegengesetzt zu der Stromflussrichtung in den Einzelspulen des anderen Paares. Alle z-Gradienten-Einzelspulen sollen dabei gleiche Windungszahlen haben.

Die Herstellung solcher Einzelspulen auf der Mantelfläche eines Trägerkörpers mit kugelförmiger Gestalt ist jedoch verhältnismässig aufwendig. Dabei müssen diese Spulen auf äusserst genau einzuhaltenden Koordinaten bezüglich des Koordinatenzentrums angeordnet sein, um die geforderten Linearitätsbedingungen erfüllen zu können.

Aufgabe der vorliegenden Erfindung ist es deshalb, dieses Gradientenspulen-System so auszugestalten, dass seine Herstellung vereinfacht ist. Dabei sollen die Vorteile eines hohlzylindrischen Trägerkörpers, wie er z.B. aus der genannten US-A 3 569 823 bekannt ist, genutzt werden können.

Diese Aufgabe wird erfindungsgemäss mit den im Kennzeichen des Hauptanspruchs angegebenen Massnahmen gelöst.

Die mit dieser Gestaltung des Gradientenspulen-Systems verbundenen Vorteile sind insbesondere darin zu sehen, dass auch bei der Verwendung eines hohlzylindrischen Trägerkörpers ein Linearitätsbereich mit den z-Gradientenspulen zu erreichen ist, der dreidimensional ausgedehnt ist. Dabei können die geometrischen Abmessungen der Einzelspulen klein gehalten werden, um somit den Strombedarf und die Induktivität der Spulen zu begrenzen. Die Gradientenfelder lassen sich dann in kurzen Zeiten ein- und ausschalten.

Vorteilhafte Ausgestaltungen des Gradientenspulen-Systems nach der Erfindung gehen aus den Unteransprüchen hervor.

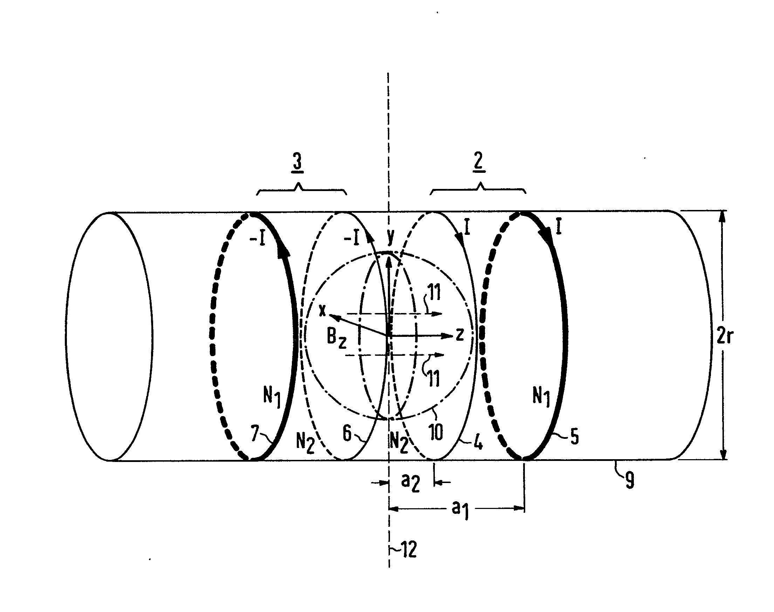

Zur weiteren Erläuterung der Erfindung und deren in den Unteransprüchen gekennzeichneten Weiterbildungen wird auf die Zeichnung Bezug genommen, in deren Figur die z-Gradientenspulen einer bildgebenden Einrichtung der Kernspinresonanz-Technik schematisch dargestellt sind.

Bei der Einrichtung der Kernspinresonanz-Technik, insbesondere zur Zeugmatographie bzw. Kernspintomographie, für welche das Gradientenspulen-System nach der Erfindung vorgesehen sein soll, wird von bekannten Magnetspulenanordnungen ausgegangen. Eine entsprechende Magnetspulenanordnung ist z.B. in der US-A 3 569 823 angedeutet. Diese Magnetspulenanordnung hat mindestens ein bezüglich der z-Achse eines rechtwinkligen x-y-z-Koordinatensystems konzentrisch angeordnetes normal- oder supraleitendes Feldspulensystem zur Erzeugung eines homogenen magnetischen Grundfeldes $B_z$ in z-Richtung. Ferner sind Gradientenspulen zur Erzeugung hinreichend konstanter magnetischer Feldgradienten in einem Abbildungsbereich vorgesehen, in dessen Zentrum sich der Koordinatenursprung des Koordinatensystems befinden soll. Die Magnetspulenanordnung erlaubt einen axialen Zugang zum homogenen Feldbereich in ihrem Zentrum, d.h. der zu untersuchende, beispielsweise menschliche Körper wird längs der z-Achse in das Magnetfeld eingebracht. Die Anregung der Kernspins erfolgt mittels eines senkrecht zur z-Achse gerichteten Hochfrequenzfeldes von Spulen, die auch als Empfängerspulen zur Aufnahme der Kernresonanzsignale dienen können.

Für eine solche Einrichtung der Kernspinresonanz-Technik kann das Gradientenspulen-System nach der Erfindung vorgesehen sein. Dieses Gradientenspulen-System umfasst z-Gradientenspulen, deren besondere Gestaltung aus der Figur der Zeichnung zu entnehmen ist. Bei den in der Figur nicht gezeigten Gradientenspulen zur Erzeugung hinreichend linearer Feldgradienten $G_x$ und $G_y$ in x- bzw. y-Richtung kann es sich um entsprechende Spulen bekannter Einrichtungen der Kernresonanz-Technik wie z.B. gemäss der US-A 3 569 823, der DE-A 28 40 178 oder der EP-A 21 535 handeln.

Das in der Figur in Schrägansicht schematisch gezeigte z-Gradientenspulen-System umfasst zwei Spulenpaare 2 und 3. Verdeckte Leiterteile sind dabei in der Figur gestrichelt wiedergegeben. Jedes Spulenpaar 2 bzw. 3 hat zwei Einzelspulen

4 und 5 bzw. 6 und 7, die auf der Aussen- und/oder Innenmantelfläche eines hohlzylindrischen Trägerkörpers 9 angeordnet sind, dessen Aussenbzw. Innenradius die Grösse r hat und dessen Zylinderachse in z-Richtung eines rechtwinkligen x-y-z-Koordinatensystems weisen soll. Diese Achse ist zugleich die Untersuchungsachse, längs derer ein zu untersuchender, beispielsweise menschlicher Körper in einen durch strichpunktierte Linien angedeuteten Untersuchungs- bzw. Abbildungsbereich 10 eingebracht werden kann. In diesem Bereich soll das durch Linien 11 angedeutete magnetische Feld $B_z$ eines Grundfeldmagneten zumindest weitgehend homogen und in z-Richtung orientiert sein. Der Koordinatenursprung des x-y-z-Koordinatensystems ist in das Zentrum des Abbildungsbereiches gelegt.

Die beiden Spulenpaare 2 und 3 sind bezüglich einer durch das Zentrum des Abbildungsbereiches verlaufenden x-y-Ebene symmetrisch angeordnet. Diese Ebene ist in der Figur durch eine punktierte, mit 12 bezeichnete Linie angedeutet. Die durch Pfeile an den ringförmigen Einzelspulen angedeuteten Stromflussrichtungen sollen dabei in den Einzelspulen 4 und 5 des Spulenpaares 2 entgegengesetzt zu der Stromflussrichtung in den Spulen 6 und 7 des anderen Spulenpaares 3 sein.

Um eine gemäss den Homogenitätsforderungen für bildgebende Einrichtungen der Kernspinresonanz-Technik ausreichende Linearität der z-Gradientenfelder zu gewährleisten, werden die von Strömen I bzw. -I durchflossenen Einzelspulen 4 bis 7 in vorbestimmten Abständen von der Symmetrieebene 12 durch das Koordinatenzentrum angeordnet. Ausserdem wird für die äusseren, d.h. für die von der Symmetrieebene weiter entfernt liegenden Einzelspulen 5 und 7 mit einer Windungszahl $N_1$ eine wesentlich grössere elektrische Durchflutung als für die der Symmetrieebene zugewandten, d.h. näher liegenden Einzelspulen 4 und 6 mit einer Windungszahl $N_2$ gewählt. Unter der elektrischen Durchflutung, auch Strombelag genannt, wird dabei das Produkt aus dem Betrag der Stromstärke I und der Windungszahl N einer Spule verstanden. Dieses Produkt wird auch als Amperewindungszahl bezeichnet.

Der Abstand $a_1$ der äusseren Einzelspulen 5 bzw. 7 von der Symmetrieebene 12 hat vorteilhaft einen Wert zwischen $0{,}9 \cdot r$ und $1{,}3 \cdot r$. Vorzugsweise wird ein Wert $1{,}1 \cdot r$ gewählt. Der Abstand $a_2$ der der Symmetrieebene 12 zugewandten Einzelspulen 4 und 6 ist von dem Abstand $a_1$ abhängig und liegt vorteilhaft zwischen $1/4 \cdot a_1$ und $1/2 \cdot a_1$. Vorzugsweise wird für ihn ein Wert von $1/3 \cdot a_1$ gewählt.

Bei einem Strom der Stärke I durch die einzelnen Windungen $N_1$ und $N_2$ der Spulen 5 und 7 bzw. 4 und 6 ist bei den genannten Abständen $a_1$ und $a_2$ der Einzelspulen 4 bis 7 von der Symmetrieebene 12 für die äusseren Einzelspulen 5 bzw. 7 eine elektrische Durchflutung $I \cdot N_1$ zu wählen, die wesentlich, d.h. mindestens 3mal grösser als die elektrische Durchflutung $I \cdot N_2$ der der Symmetrieebene näher liegenden Einzelspulen 4 bzw.

6 ist. Vorteilhaft liegt das Verhältnis $(I \cdot N_1)$ : $(I \cdot N_2)$ der Durchflutungen zwischen 6:1 und 12:1. Vorzugsweise wird ein Verhältnis von etwa 9:1 vorgesehen.

Gemäss dem Ausführungsbeispiel nach der Figur wurde davon ausgegangen, dass der Betrag des Stromes I durch die vier Einzelspulen 4 bis 7 gleich ist und nur die Windungszahlen $N_1$ und $N_2$ verschieden sind. Um die vorbestimmten Werte für die elektrische Durchflutung $I \cdot N_1$ bzw. $I \cdot N_2$ durch die Spulen 5, 7 bzw. 4, 6 zu erhalten, ist es jedoch ebenso möglich, in den Spulen 4 und 6 einen Strom einzustellen, der gegenüber dem Strom durch die Spulen 5 und 7 verschieden gross ist.

Mit den genannten Werten für die Abstände $a_1$ und $a_2$ sowie für die elektrischen Durchflutungen $I \cdot N_1$ und $I \cdot N_2$ können vorteilhaft weitgehend konstante Feldgradienten $G_z$ in einem Abbildungsbereich 10 erreicht werden, dessen Volumen annähernd kugelförmige Gestalt mit einem Radius von etwa $2/3 \cdot r$ hat.

## Patentansprüche

1. Gradientenspulen-System für eine Einrichtung zur Erzeugung von Abbildungen eines Objektes mit Hilfe der Kernspinresonanz-Technik, insbesondere für die Zeugmatographie, mit

– einem rotationssymmetrischen Trägerkörper (9), der einen Abbildungsbereich (10) umschliesst und dessen die z-Achse eines rechtwinkeligen x-y-z-Koordinatensystems definierende Rotationsachse der Richtung des Grundmagnetfeldes $B_z$ der Einrichtung entspricht,

– zwei Paaren (2, 3) von ringförmigen Einzelspulen (4–7), die zur Erzeugung eines in dem Abbildungsbereich (10) im wesentlichen konstanten Magnetfeldgradienten $G_z = \partial B_z / \partial z$ entlang der z-Achse auf dem Trägerkörper (9) angeordnet sind, wobei das eine Paar (2) von ringförmigen Einzelspulen (4, 5) symmetrisch zu dem anderen Paar (3) von ringförmigen Einzelspulen (6, 7) bezüglich einer durch den Abbildungsbereich (10) senkrecht zur z-Achse verlaufenden und die x-y-Ebene des Koordinatensystems bildenden Querschnittsebene (12) angeordnet ist, und wobei die Stromflussrichtung in den Einzelspulen (4, 5) des einen Paares (2) zur Stromflussrichtung in den Einzelspulen (6, 7) des anderen Paares (3) entgegengesetzt ist, sowie

– mindestens einem Satz von bezüglich der Querschnittsebene (12) symmetrischen und zur Erzeugung von in dem Abbildungsbereich (10) im wesentlichen konstanten Feldgradienten $G_x = \partial B_z / \partial x$ in x-Richtung angeordneten Einzelspulen und mindestens einem weiteren Satz von Einzelspulen zur Erzeugung entsprechender Feldgradienten $G_y = \partial B_z / \partial y$ in y-Richtung, dadurch gekennzeichnet, dass

a) der Trägerkörper (9) ein Hohlzylinder mit einem Radius r ist und

b) die Amperewindungszahl $(I \cdot N_1)$ der bezüglich der Querschnittsebene (12) weiter entfernt liegenden Einzelspulen (5, 7) der beiden Spulenpaare (2, 3) grösser ist als die Amperewindungs-

zahl $(I \cdot N_2)$ der zugehörigen, näher liegenden Einzelspulen (4, 6).

2. Gradientenspulen-System nach Anspruch 1, dadurch gekennzeichnet, dass der Abstand $(a_1)$ der von der Querschnittsebene (12) weiter entfernt liegenden Einzelspulen (5, 7) zwischen $0,9 \cdot r$ und $1,3 \cdot r$ liegt.

3. Gradientenspulen-System nach Anspruch 2, gekennzeichnet durch einen Abstand $(a_1)$ der von der Querschnittsebene (12) weiter entfernt liegenden Einzelspulen (5, 7) von etwa $1,1 \cdot r$.

4. Gradientenspulen-System nach einem der Ansprüche 1 bis 3, dadurch gekennzeichnet, dass der Abstand $(a_2)$ der der Querschnittsebene (12) näher liegenden Einzelspulen (4, 6) zwischen $1/4$ und $1/2$ des entsprechenden Abstandes $(a_1)$ der weiter entfernt liegenden Einzelspulen (5, 7) beträgt.

5. Gradientenspulen-System nach Anspruch 4, gekennzeichnet durch einen Abstand $(a_2)$ der der Querschnittsebene (12) näher liegenden Einzelspulen (4, 6) von etwa $1/3$ des Abstandes $(a_1)$ der weiter entfernt liegenden Einzelspulen (5, 7).

6. Gradientenspulen-System nach einem der Ansprüche 1 bis 5, dadurch gekennzeichnet, dass die Amperewindungszahl $(I \cdot N_1)$ der bzgl. der Querschnittsebene (12) weiter entfernt liegenden Einzelspulen (5, 7) der beiden Spulenpaare ($\underline{2}$, $\underline{3}$) zwischen dem Sechsfachen und dem Zwölffachen der Amperewindungszahl $(I \cdot N_2)$ der näher liegenden Einzelspulen (4, 6) beträgt.

7. Gradientenspulen-System nach Anspruch 6, gekennzeichnet durch eine etwa 9mal grössere Amperewindungszahl $(I \cdot N_1)$ der bzgl. der Querschnittsebene (12) weiter entfernt liegenden Einzelspulen (5, 7) im Vergleich zu der Amperewindungszahl $(I \cdot N_2)$ der näher liegenden Einzelspulen (4, 6).

8. Gradientenspulen-System nach Anspruch 6 oder 7, dadurch gekennzeichnet, dass die Stromstärke in den Windungen $(N_1)$ der bzgl. der Querschnittsebene (12) weiter entfernt liegenden Einzelspulen (5, 7) verschieden von der Stromstärke in den Windungen $(N_2)$ der näher liegenden Einzelspulen (4, 6) ist.

**Revendications**

1. Système de bobines à gradient pour un dispositif servant à réaliser des images d'un objet à l'aide de la technique de résonance magnétique nucléaire, notamment pour la zeugmatographie, comportant

– un corps de support (9) à symétrie de révolution, qui entoure une zone (10) de formation d'images et dont l'axe de rotation, qui définit l'axe z d'un système de coordonnées rectangulaires x-y-z, correspond à la direction du champ magnétique principal $B_z$ du dispositif,

– deux couples ($\underline{2}$, $\underline{3}$) de bobines individuelles et annulaires (4–7), qui sont disposées le long de l'axe z sur le corps de support (9) en vue de produire un gradient de champ magnétique $G_z = \partial B_z / \partial z$, essentiellement constant dans la zone (10) de formation d'images, un couple ($\underline{2}$) de bobines individuelles annulaires (4, 5) étant disposé symétriquement par rapport à l'autre couple ($\underline{3}$) de bobines individuelles annulaires (6, 7) par rapport à un plan de coupe transversal (12) s'étendant perpendiculairement à l'axe z à travers la zone (10) de formation d'images et constituant le plan x-y du système de coordonnées, le sens du flux de courant dans les bobines individuelles (4, 5) d'un couple ($\underline{2}$) étant opposé au sens du flux de courant dans les bobines individuelles (6, 7) de l'autre couple ($\underline{3}$), ainsi que

– au moins un ensemble de bobines individuelles symétriques par rapport au plan de coupe transversal (12) et disposées de manière à produire des gradients de champ $G_x = \partial B_z / \partial x$, essentiellement constants dans la zone (10) de formation d'images, suivant la direction x et au moins un autre ensemble de bobines individuelles servant à produire des gradients de champ correspondant $G_y = \partial B_z / \partial y$ suivant la direction y, caractérisé par le fait que

a) le corps de support (9) est un cylindre creux possédant un rayon r, et

b) le nombre d'ampère-tours $(I \cdot N_1)$ des bobines individuelles (5, 7) qui sont les plus éloignées du plan de coupe transversal (12), des deux couples de bobines ($\underline{2}$, $\underline{3}$) est supérieur au nombre d'ampère-tours $(I \cdot N_2)$ des bobines individuelles associées (4, 6), plus rapprochées.

2. Système de bobines à gradient suivant la revendication 1, caractérisé par le fait que la distance $(a_1)$ des bobines individuelles (5, 7) les plus éloignées du plan de coupe transversal (12) est située entre $0,9 \cdot r$ et $1,3 \cdot r$.

3. Système de bobines à gradient suivant la revendication 2, caractérisé par le fait que la distance $(a_1)$ des bobines individuelles (5, 7) les plus éloignées du plan de coupe transversal (12) est égal à environ $1,1 \cdot r$.

4. Système de bobines à gradient suivant l'une des revendications 1 à 3, caractérisé par le fait que la distance $(a_2)$ des bobines individuelles (4, 6) qui sont les plus rapprochées du plan de coupe transversal (12), est comprise entre $1/4$ et $1/2$ de la distance correspondante $(a_1)$ des bobines individuelles (5, 7) les plus éloignées.

5. Système de bobines à gradient suivant la revendication 4, caractérisé par le fait que la distance $(a_2)$ du plan de coupe transversal (12) des bobines individuelles (4, 6) les plus rapprochées est égale à environ $1/3$ de la distance $(a_1)$ des bobines individuelles (5, 7) les plus éloignés.

6. Système de bobines à gradient suivant l'une des revendications 1 à 5, caractérisé par le fait que le nombre d'ampère-tours $(I \cdot N_1)$ des bobines individuelles (5, 7) les plus éloignées du plan de coupe transversal (12) des deux couples de bobines ($\underline{2}$, $\underline{3}$) est compris entre six fois et douze fois le nombre d'ampère-tours $(I \cdot N_2)$ des bobines individuelles (4, 6) les plus rapprochées.

7. Système de bobines à gradient suivant la revendication 6, caractérisé par le fait que le nombre d'ampère-tours $(I \cdot N_1)$ des bobines individuelles (5, 7) les plus éloignées du plan de coupe transversal (12) est égal à environ 9 fois le nombre d'ampère-tours ($I \cdot N_2$) des bobines individuelles (4, 6) les plus rapprochées.

8. Système de bobines à gradient suivant la revendication 6 ou 7, caractérisé par le fait que l'intensité du courant dans les spires ($N_1$) des bobines individuelles (5, 7) les plus éloignées du plan de coupe transversal (12) est différente de l'intensité du courant dans les spires ($N_2$) des bobines individuelles (4, 6) les plus rapprochées.

## Claims

1. A gradient coil system for a device for the production of images of an object, using nuclear magnetic resonance technology, in particular for zeugmatography, with
 – a rotation-symmetrical carrier body (9) which encloses an imaging zone (10) and whose axis of rotation, which defines the z-axis of a rectangular x-y-z co-ordinate system, corresponds to the direction of the basic magnetic field $B_z$ of the device,
 – two pairs (2, 3) of annular separate coils (4–7) which are arranged on the carrier body (9) in order to produce a magnetic field gradient $G_z = \partial B_z / \partial z$, which is essentially constant in the imaging zone (10), along the z-axis, where the first pair (2) of annular separate coils (4, 5) is arranged to be symmetrical to the other pair (3) of annular separate coils (6, 7) relative to a cross-sectional plane (12) which passes through the imaging zone (10) at right-angles to the z-axis and which forms the x-y plane of the co-ordinate system, and where the current flux direction in the separate coils (4, 5) of the first pair (2) is opposed to the current flux direction in the separate coils (6, 7) of the other pair (3), and
 – at least one set of separate coils which are symmetrical relative to the cross-sectional plane (12) and which serve to produce field gradients $G_x = \partial B_z / \partial x$, which are essentially constant in the imaging zone (10), in the x-direction, and with at least one further set of separate coils which serves to produce corresponding field gradients $G_y = \partial B_z / \partial y$ in the y-direction, characterised in that
 a) the carrier body (9) is a hollow cylinder having a radius r and

 b) the number of ampere-turns ($I \cdot N_1$) of those separate coils (5, 7) of the two pairs of coils (2, 3), which lie further from the cross-sectional plan (12) is greater than the number of ampere-turns ($I \cdot N_2$) of the associated, nearer separate coils (4, 6).

2. A gradient coil system as claimed in claim 1, characterised in that the distance ($a_1$) of the separate coils (5, 7) which lie further from the cross-sectional plane (12) is between $0.9 \cdot r$ and $1.3 \cdot r$.

3. A gradient coil system as claimed in claim 2, characterised by a distance ($a_1$) of the separate coils (5, 7) which lie further from the cross-sectional plane (12) of approximately $1.1 \cdot r$.

4. A gradient coil system as claimed in one of the claims 1 to 3, characterised in that the distance ($a_2$) of the separate coils (4, 6) which lie closer to the cross-sectional plane (12) amount to between $1/4$ and $1/2$ of the corresponding distance ($a_1$) of the more remote separate coils (5, 7).

5. A gradient coil system as claimed in claim 4, characterised by a distance ($a_2$) of the separate coils (4, 6) which are closer to the cross-sectional plane (12) of about $1/3$ of the distance ($a_1$) of the more remote separate coils (5, 7).

6. A gradient coil system as claimed in one of the claims 1 to 5, characterised in that the number of ampere-turns ($I \cdot N_1$) of those separate coils (5, 7) of the two pairs of coils (2, 3) which lie further from the cross-sectional plane (12) amounts to between six times and 12 times the number of ampere-turns ($I \cdot N_2$) of the nearer separate coils (4, 6).

7. A gradient coil system as claimed in claim 6, characterised by an approximately nine time greater number of ampere-turns ($I \cdot N_1$) of the separate coils (5, 7) which lie further from the cross-sectional plane (12) in comparison to the number of ampere-turns ($I \cdot N_2$) of the nearer separate coils (4, 6).

8. A gradient coil system as claimed in claim 6 or 7, characterised in that the current strength in the turns ($N_1$) of the separate coils (5, 7) which lie further from the cross-sectional plane (12) differs from the current strength in the turns ($N_2$) of the nearer separate coils (4, 6).

1/1